# EUROPEAN PATENT SPECIFICATION

(11) **EP 4 248 227 B1**
(45) Date of publication and mention of the grant of the patent: **25.11.2026**
(21) Application number: 22852475.7
(22) Date of filing: 13.09.2022
(51) Int. Cl.: G01R 31/28

(54) **A RIG FOR COMPARING WIRE HARNESSES**
VORRICHTUNG ZUM VERGLEICHEN VON KABELBÄUMEN
ÉQUIPEMENT POUR COMPARER DES FAISCEAUX DE CÂBLES

(30) Priority: 04.08.2021 IN 202121035064
(43) Date of publication of application: 27.09.2023
(73) Proprietor: Patki, Sandeep Suhas, Pune-411052, Maharashtra (IN)
(72) Inventor: Patki, Sandeep Suhas, Pune-411052, Maharashtra (IN)
(74) Representative: Dr. Gassner & Partner mbB
(86) International application number: PCT/IB2022/058617
(87) International publication number: WO 2023/012772

(56) References cited:
- CN-U- 213 689 901
- US-A1- 2010 010 758
- US-A1- 2010 010 758
- US-A1- 2010 268 507
- US-A1- 2013 162 262
- US-A1- 2013 162 262

## Description

### Field of the Invention

The present invention provides a rig for wire harnesses. More specifically, the present invention provides a rig for comparing two or more wire harnesses.

### Background of the Invention

Generally, Wire harness(es) are typically used to provide electrical connectivity or any such connectivity and transmit signals (control signals) between functional units of devices in an aircraft, a spacecraft, a vehicle, a boat and the like. Further, the wire harness is used in wide applications such as electronic devices, home appliances, home automation systems, automobiles, construction machinery and the like. Typically, a wire harness includes one or more wire segments, and two or more connector ends. Two or more connector ends one or more wire segments.

Presently, after manufacturing a wire harness, the wire harness is compared with a standard wire harness (generally referred to as a "Master circuit" in the wire harness industry) by subjecting the wire harness to supply one or more electrical parameters thereto. Electrical parameters are an electromotive force (emf) or an electrical potential or charge or voltage or current or resistance or impedance or capacitance or utility frequency or combinations. The measured values of electrical parameters of the wire harness are compared with measured values of electrical parameters of the standard wire harness. Generally, in the wire harness industry, this process is referred to as **"wire harness testing".**

Presently, to test (compare) wire harnesses, some testing rigs are available. The existing testing rigs include a workbench, a processor for comparing, two or more terminals arranged on the workbench. The terminals are adapted to receive one or more connector ends of the wire harness, and each terminal is electrically coupled with a supply device. The supply device is adapted to supply one or more electrical parameters to one or more terminals when the supply device is operated accordingly. In the presently available testing rigs, the connections between the processor, the terminals and the supply device are wired. Due to the wired connections, the construction of the testing rig is complex, which makes the rig costlier. The construction of the available testing rigs is complicated and not easy to operate.

For every new requirement (to compare a new wire harness with a standard wire harness), a new test rig needs to be constructed (prepared). Hence, there is an additional cost for a new rig for every modified wire harness that needs to be tested. This construction of a new rig for every new wire harness increases the testing and ultimately the overall manufacturing cost of the wire harness.

Presently, some test rigs with wireless connections between the terminals coupled with connector ends of the wire harness.

The patent document TW202036014A discloses a "Wireless electronic-control system". The control system fails to save details of a standard wire harness provided. Also, the control system is not suitable for testing a new wire harness using the same workbench and related arrangements of the system provided. Document US 2013/0162262 A1 (D1) discloses a system for wire harness testing using TDR-based measurements and waveform analysis, but does not store circuit configurations or control test setups wirelessly.

Document US 2010/0268507 A1 (D2) describes a system using a central host computer to control test modules and store test outcomes, but lacks structured circuit storage, dynamic reconfiguration, and wireless topology options.

The present invention seeks to address these limitations by enabling programmable, topology-configurable testing and structured comparison using stored harness data.

Therefore, there is a need for a rig, which overcomes problems from the prior art.

### Objects of the Invention

An object of the present invention is to provide a rig for wire harnesses.

An object of the present invention is to provide a rig for wire harnesses, wherein the rig is used to compare two or more wire harnesses.

Another object of the present invention is to provide a rig for wire harnesses, wherein the rig is simple in construction compared to existing testing rigs.

Further object of the present invention is to provide a rig for wire harnesses, wherein the rig reduces the testing cost of wire harnesses compared to existing testing rigs.

Further, an object of the present invention is to provide a rig for wire harnesses, wherein the rig is easy to operate.

Also, an object of the present invention is to provide a rig for wire harnesses, wherein the rig provides various ways, or modes of storing standard wire harness details in a memory unit of the rig for comparing with other wire harnesses, the details of comparisons can be used to track errors occurred (manual or operational errors) during testing (comparison) operations.

### Summary of the invention

The present invention provides a rig for comparing wire harnesses according to claim 1 of the appended claims. The rig includes a workbench, two or more terminals, an electrical supply, a supply device, two or more control units and a workstation.

The terminals are arranged on the workbench. The terminals are adapted to receive one or more connector ends of the wire harness. Each wire harness includes one or more wire segments, and two or more connector ends. The connector ends connect one or more wire segments. Each terminal is electrically coupled with an electric supply. The each terminal is connected to the supply device for receiving electrical parameters therefrom. The electrical parameter is an electrical continuity, an electromotive force (emf) or electrical potential or charge or resistance or impedance or capacitance or utility frequency along with the first or second wire harness.

When the first wire harness is connected to the terminals, the electric supply is supplied from a first terminal to a second terminal through the first wire harness in a first cycle of supply. Also, the electric supply is supplied from the second terminal to the first terminal through the first wire harness in a second cycle of supply.

The control unit is connected to the respective terminal. The control unit is adapted to sense electrical parameters at the respective terminal.

The workstation is connected to the control units through a wireless connection. The workstation is a computer or a mobile or a tablet or a smartphone or a kiosk, or an IoT device. In a preferred embodiment, the wireless connection is wifi. In an alternative embodiment, the wireless connection is an internet or a radio frequency connection. In the preferred embodiment, a topology of the wireless connection is a mesh topology. In an alternative embodiment, the topology of the wireless connection can be a partially connected mesh, a ring topology, a dual ring topology, a star topology, an extended star topology, a tree topology, a bus topology, hybrid topologies or a combination thereof.

The workstation is having a memory unit and a processor. The memory unit stores prestored circuitry details of the first wire harness. The details of circuitry include a number of junctions (nodes), a number of wire segments, connectivity between the wire segments, an electrical continuity or voltage drop along with the wire segments and also along with the wire harness. Further, the details of circuitry include charge density in the junctions when the wire harness is supplied with a predefined quantity of current. The workstation receives sensed signals from the control units. Further, the workstation sends actuation signals to the control units.

**In** a preferred embodiment of the control unit, the control unit includes a transceiver and a sensing unit. The transceiver receives signals from the workstation and sends signals to the workstation. The sensing unit senses the electrical parameter. The sensing unit is electrically coupled to the terminal. The sensing unit is connected to the transceiver for sending sensed signals to the transceiver.

**In** an alternative embodiment of the control unit, the control unit also includes a regulating unit. The regulating unit is connected to the transceiver, the supply device and the respective terminal. As per the instructions received at the transceiver from the work station, the control unit regulates the supply of electric parameters to the terminal from the supply device.

**In** a preferred embodiment, the control unit is powered by the supply device. The supply device is a battery. **In** a preferred embodiment, the supply device has an interface for controlling operations of the supply device.

**In** a preferred embodiment, the circuitry details are stored in the memory unit by connecting the first wire harness to the corresponding terminals. Further, the terminals are provided with an electric supply. The workstation collects information about the sensed electrical parameter(s) at the terminals. The collected information is stored as the circuitry details in the memory unit of the work station. Upon storing the circuitry details of a first wire harness stored in the memory unit, the workstation modifies the connections between the terminals according to the first wire harness by actuating and nullifying the respective control units.

In one more alternative embodiment, upon storing the circuitry details of a first wire harness stored in the memory unit, the workstation modifies the connections between the terminals according to the first wire harness by sending the instructions to the transceiver to actuate the control unit for regulating the supply of electric parameters to the terminal from the supply device according to the first wire harness.

Upon connecting a second wire harness to the respective terminals, the electric supply is supplied to the terminals. When the second wire harness is connected to the terminals, the electric supply is supplied from the first terminal to the second terminal through the second wire harness in a third cycle of supply. Also, the electric supply is supplied from the second terminal to the first terminal through the second wire harness in a fourth cycle of supply.

The control units send sensed signals to the workstation. The processor compares the sensed signals from the control units with the prestored circuitry details of the first wire harness. The processor provides comparison details through a display connected therewith.

In an alternative embodiment, the work station is connected to the supply device to control the electric supply from the supply device. In an alternative embodiment, the workstation has a user interface to configure the circuitry details of the first wire harness.

In one more alternative embodiment, the circuitry details are stored in the memory unit by connecting the memory unit to an external device. The external device is a pen drive or a hard drive or a server or a cloud, or an IoT device.

In one more alternative embodiment of the rig, the rig includes a plurality of workstations and a plurality of workbenches. The work stations are connected to a server or a cloud server, the circuitry details of the first wire harness are updated in the respective memory units of workstations. The details of comparison, cycles of comparisons are updated in a cloud memory of the cloud server in real-time.

Furthermore, in an alternative embodiment of the rig, the rig is connected to an authentication system. The authentication system is adapted to provide access to the rig to an authenticated user only when the authentication system is operated accordingly.

The present invention also provides a method for comparing wire harnesses according to claim 15 of the appended claims. The method includes a step of arranging the two or more terminals on the workbench. The terminals are adapted to receive one or more connector ends of the wire harness. Each terminal is electrically coupled with the electric supply. Further, each terminal is connected with a respective control unit of two or more control units. The control units are connected to a workstation through a wireless network. The workstation is having a memory unit and a processor. Furthermore, the circuitry details of the first wire harness of the wire harnesses are stored in the memory unit.

The second wire harness of the wire harnesses is connected to the terminals. The electric supply is supplied to the terminals, thereby supplying the electrical parameters to the second wire harness. The control units are adapted to send information about the sensed electrical parameter(s) at the terminals to the work station through the wireless network. The processor is adapted to compare the received information from the control units with the prestored circuitry details of the first wire harness. The processor is adapted to provide comparison details through a display connected therewith.

### Brief Description of the Drawings

The advantages and features of the present invention will be understood better with reference to the following detailed description of some embodiments and claims taken in conjunction with the accompanying drawings, wherein like elements are identified with like symbols, and in which;
Figure 1a shows a schematic block diagram of a rig for comparing wire harnesses in accordance with the present invention;
Figure 1b shows a schematic block diagram of an alternative embodiment of a rig for comparing wire harnesses in accordance with the present invention;
Figure 1c shows a schematic block diagram of a star topology network between control units and a work station of the rig shown in figure 1a and 1b;
Figure 1d shows a schematic block diagram of a bus topology network (alternative embodiment) between control units and a work station of the rig shown in figure 1a and 1b;
Figure 1e shows a schematic block diagram of a mesh topology network (alternative embodiment) between control units and a work station of the rig shown in figure 1a and 1b;
Figure 1f shows a schematic block diagram of a ring topology network (alternative embodiment) between control units and a work station of the rig shown in figure 1a and 1b;
Figures 1g and 1i show a schematic front view and a schematic top view of a first wire harness connected to terminals of the rig shown in figure 1a and 1b;
Figures 1h and 1j show a schematic front view and a schematic top view of a second wire harness connected to terminals of the rig shown in figure 1a and 1b;
Figure 2 shows a schematic block diagram of a control unit of the rig shown in figure 1a;
Figure 3 shows a schematic block diagram of a control unit of the rig shown in figure 1b;
Figure 4 shows a schematic block diagram of a connection between a supply device and control units of the rig shown in figures 1a and 1b;
Figure 5 shows a schematic block diagram of an alternative embodiment of the supply device shown in figure 4;
Figure 6 shows a flow chart showing various steps carried out in a method for storing circuitry details in a memory unit of a workstation of the rig shown in figure 1a and figure 1b;
Figure 7 shows a schematic block diagram of an alternative embodiment connection between the workstation and the supply device shown in figure 5, figure 1a and figure 1b;
Figure 8 shows a schematic block diagram of an alternative embodiment of a rig for comparing wire harnesses in accordance with the present invention;
Figure 9 shows a schematic block diagram of one more alternative embodiment of a rig for comparing wire harnesses in accordance with the present invention; and
Figure 10 shows a flow chart showing various steps carried out in a method for comparing wire harnesses in accordance with the present invention.

### Detailed Description of the Invention

An embodiment of this invention, illustrating its features, will now be described in detail. The words "comprising", "having", "containing," and "including," and other forms thereof are intended to be equivalent in meaning and be open-ended in that an item or items following any one of these words is not meant to be an exhaustive listing of such item or items or meant to be limited to only the listed item or items.

The terms "first," "second," and the like, herein do not denote any order, quantity, or importance, but rather are used to distinguish one element from another, and the terms "an" and "a" herein do not denote a limitation of quantity, but rather denote the presence of at least one of the referenced items.

The disclosed embodiments are merely exemplary of the invention, which may be embodied in various forms, since the scope of protection of the present invention is defined by the appended claims.

The present invention provides a rig for wire harnesses. The rig is used to compare two or more wire harnesses. The rig is simple in construction compared to existing testing rigs. The rig reduces the testing cost of wire harnesses compared to existing testing rigs. The rig is easy to operate. The rig provides various ways or modes of storing standard wire harness details in a memory unit of the rig for comparison with other wire harnesses.

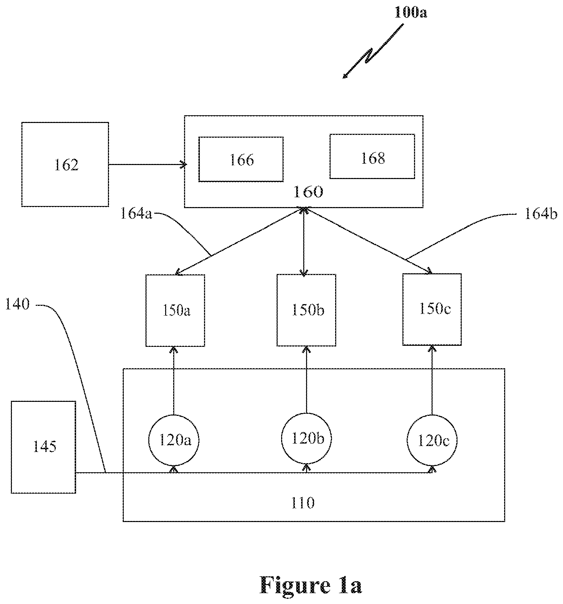

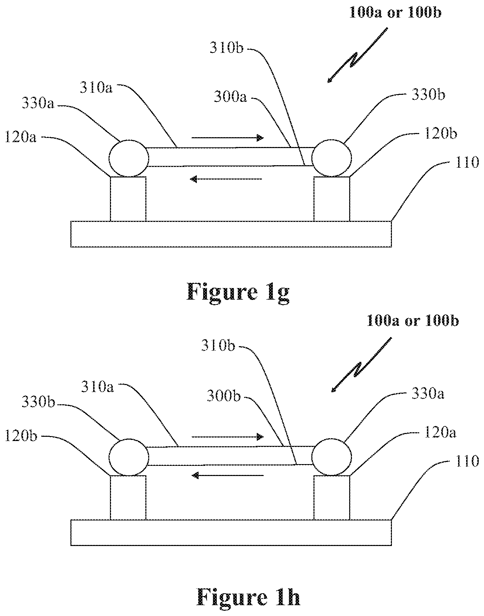

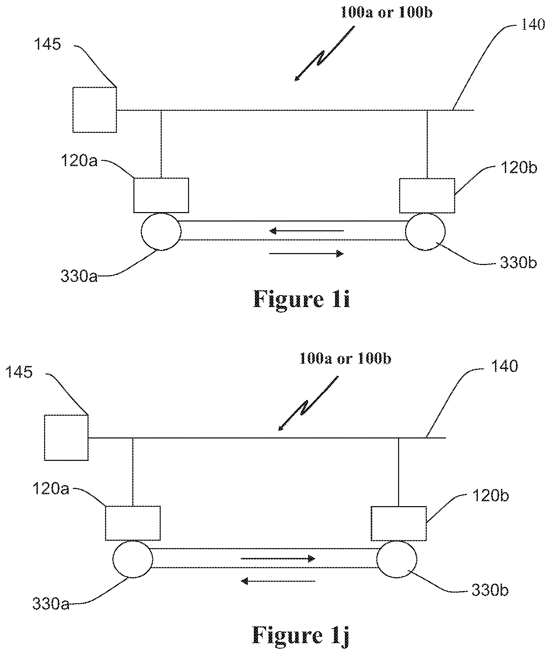

Referring to Figure 1a, a schematic view of a rig for comparing wire harnesses in accordance with the present invention is illustrated. From herein afterwards, the rig is referred to as a rig (100a). The rig (100a) is for wire harnesses (300a or 300b) (figures 1g, 1h, 1i and 1j). The rig (100) includes a workbench (110), two or more terminals (120a, 120b, 120c), an electrical supply (140), a supply device (145), one or more control units (150a, 150b, 150c) and a workstation (160).

Generally, the terminals (120a, 120b) are arranged on the workbench (110). In a preferred embodiment, the terminals (120a, 120b) are fixed to the workbench (110). In one more embodiment, the terminals (120a,120b) are movebly arranged on the workbench (110). The terminals (120a, 120b) are adapted to receive one or more connector ends (302a, 304a, 302b, 304b) of the wire harness (300a, 300b) (refer to figure 1g and 1h). Each wire harness (300a, 300b) includes one or more wire segments (310a, 310b) and two or more connector ends (302a, 304a, 302b, 304b). The connector ends (302a, 304a, 302b, 304b) connects one or more wire segments (310a, 310b). For example, connector ends (302a, 304a) connects the wire segment (310a).

Each terminal (120a, 120b) is electrically coupled with an electric supply (140). The each terminal (302a, 304a) is connected to the supply device (145) for receiving electrical parameters therefrom. The electrical parameter is an electrical continuity, an electromotive force (emf) or electrical potential or charge or resistance or impedance or capacitance or utility frequency along with the first or second wire harness (300a or 300b). For example, the wire harness (300a or 300b) is supplied with 5 Ampere of electric current and 5 Volts of electric voltage. Generally, for continuity testing, the wire is supplied with a few amperes of electrical current.

When the first wire harness (300a) is connected to the terminals (120a, 120b), the electric supply (140) is supplied from a first terminal (120a) to a second terminal (120b) through the first wire harness (300a) in a first cycle of supply (801). Also, the electric supply (140) is supplied from the second terminal (120b) to the first terminal (120a) through the first wire harness (300a) in a second cycle of supply(802). The first wire harness (300a) can be standard if the rig (100a) is used to harness testing operations. Generally, in the industry (wire harness industry), the first wire harness (300a) is referred to as a "master circuit" if the rig (100a) is used for the wire harness testing operations.

The control unit (150a or 150b) is connected to the respective terminal (120a, 120b). The control unit (150a, 150b) is adapted to sense electrical parameters at the respective terminal (120a, 120b).

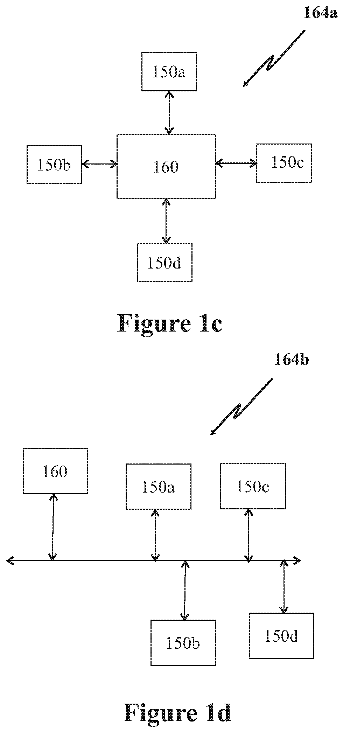

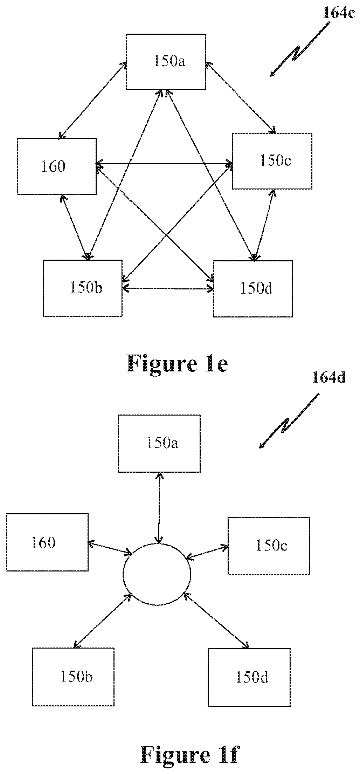

The workstation (160) is connected to the control units (150a, 150b) through a wireless connection (164). The workstation (160) is a computer or a mobile or a tablet or a smartphone or a kiosk, or an IoT (Internet Of Things) device. In a preferred embodiment, the wireless connection (164) is wifi (Wireless Fidelity). In an alternative embodiment, the wireless connection (164) is an internet or a radio frequency connection. In the preferred embodiment, as shown in figure 1c, a topology of the wireless connection (164) is a star topology (164a). In an alternative embodiment, the topology of the wireless connection (164) can be a partially connected mesh, a ring topology (164d) (refer to figure 1f), a dual ring topology, a star topology (164a) (refer to figure 1c), an extended star topology, a tree topology, a bus topology (164b) (refer figure 1d), a mesh topology (164c) (refer figure 1e), hybrid topologies or combination thereof.

Further, the workstation (160) is having a memory unit (168) and a processor (166). The processor (166) is connected to the memory unit (168). The memory unit (168) stores prestored circuitry details of the first wire harness (300a). The details of circuitry include a number of junctions (nodes), a number of wire segments (310a, 310b), connectivity between the wire segments (310a, 310b), an electrical continuity or voltage drop along with the wire segments (310a, 310b) and also along with the wire harness (300a, 300b). Further, the details of circuitry include charge density in the junctions when the wire harness (300a, 300b) is supplied with a predefined quantity of current.

Further, the circuitry details include measured electric parameters at respective terminals (120a or 120b). **In** a given an example, the circuitry details of the first wire harness (300a) shown in figure 1g include a supply voltage of 5V, a current of 5A, two junctions, the energy of 5J and the like. The circuitry details can be modified based on requirements by varying the supplied parameters.

The workstation (160) receives sensed signals from the control units (150a, 150b). Further, the workstation (160) sends actuation signals to the control units (150a, 150b). Each control unit (150a, 150b) is embedded with a set of hardware and software.

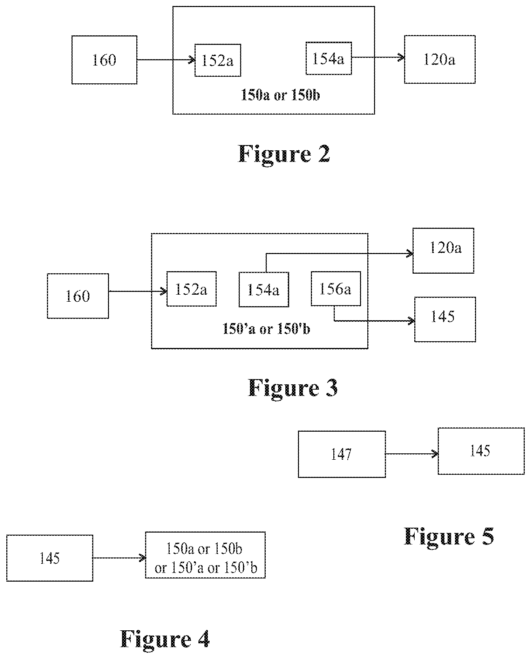

**In** a preferred embodiment of the control unit (150a, 150b), the control unit (150a, 150b) includes a transceiver (152a, 152b) and a sensing unit (154a, 154b) (refer figure 2). The transceiver (152a, 152b) includes a receiver receiving signals from the workstation (160). The transceiver (152a, 152b) includes a transmitter for sending signals to the work station (160). The transceiver (152a, 152b) receives and sends information through the wireless network(164). The sensing unit (154a, 154b) senses the electrical parameter. The sensing unit (154a, 154b) is electrically coupled to the terminal (120a, 120b). The sensing unit (154a, 154b) is connected to the transceiver (152a, 152b) for sending sensed signals to the transceiver (152a, 152b). The sensing unit (154a, 154b) can be an electrical sensor or a detector or a transducer.

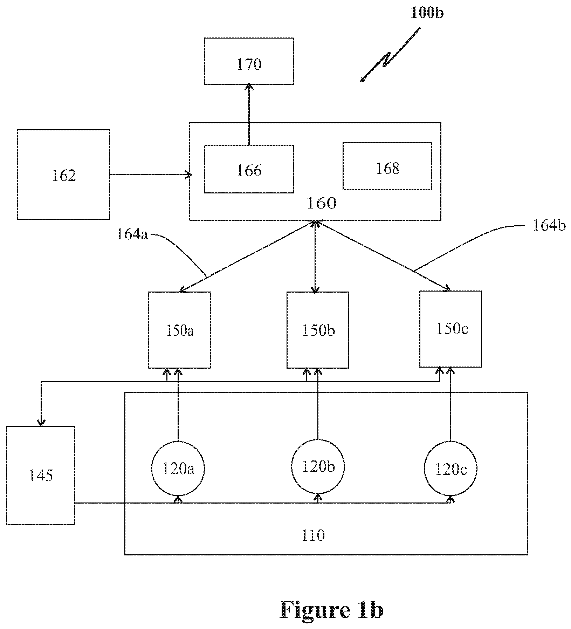

**In** an alternative embodiment of the control unit (150'a, 150'b) (figure 3), the control unit (150'a, 150'b) also includes a regulating unit (156a, 156b). The regulating unit (156a, 156b) includes a voltage regulator, transformers, diodes, relays, electric switches, or any other functional units adapted to regulate the electric supply parameter(s) together or separately. The regulating unit (156a, 156b) is connected to the transceiver (152a, 152b), the supply device (145) and the respective terminal (120a, 120b) (figure 1b). As per the instructions received at the transceiver (152a, 152b) from the work station (160), the control unit (150'a, 150'b) regulates the supply of electric parameters to the terminal (120a, 120b) from the supply device (145).

In a preferred embodiment, the control unit (150a, 150á 150b, 150'b) is powered by the supply device (145) (figure 4). The supply device (145) is a battery. In one more embodiment, the supply device (145) is having an interface (147) for controlling operations of the supply device 145 (figure 5). A user can operate the supply device (145) through the interface (147) for supplying the required electric parameters.

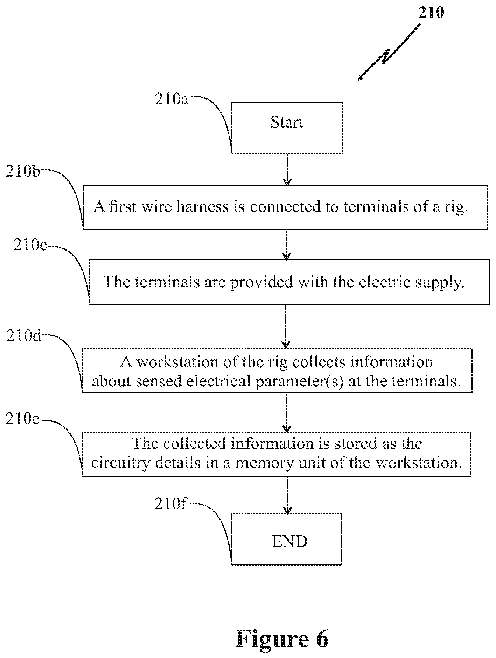

Referring now to figure 6, showing a flow chart of a method (210) for storing the circuitry details in the memory unit (168). The method (210) is a preferred method to store the circuitry details in the memory unit (168). The method starts at step 210a. At step 210b, the first wire harness (300a) is connected to the corresponding terminals (120a, 120b) (refer to figure 1g). Further, at step 210c, the terminals (120a, 120b) are provided with an electric supply (140) (refer to figure (1i)). At step 210d, the workstation (160) collects information about sensed electrical parameter(s) at the terminals (120a, 120b). Furthermore, at step 210e, the collected information is stored as the circuitry details in the memory unit (168) of the work station (160).

In an alternative embodiment, the workstation (160) has a user interface (162) (figure 1a) to configure the circuitry details of the first wire harness (300a). The workstation (160) is having software such as Electrical computer-aided design and drafting (E-CADD) software, computer-aided engineering (CAE) software and Computer-Aided Manufacturing (CAM) software. Using this software, a user can configure the circuitry details of the first wire harness (300a) in the work station (160).

In one more alternative embodiment, the circuitry details are stored in the memory unit (168) by connecting the memory unit (168) to an external device (not shown). The external device (400) is a pen drive or a hard drive or a server or a cloud, or an IoT device.

Upon storing the circuitry details of the first wire harness (300a) in the memory unit (168), the workstation (160) modifies the connections between the terminals (120a & 120b) according to the first wire harness (300a) by actuating and nullifying the respective control units (150a, 150b). This way of nullification can be seen in the embodiment shown in figure 1a (the rig (100a)).

Though the supply device (145) supplies electric supply (140) to the terminals (120a, 120b), the control units (150a, 150b, 150c) are not able to sense the signals from electric supplied terminals (120a, 120b, 120c) due to nullification of the respective control units (150a, 150b, 150c).

In the shown example (refer to figure 1a), the first circuitry details include only two or more connector ends (302a, 304a). The electric supply (140) is supplied to all terminals (120a, 120b, 120c). Even though the terminals (120a, 120b, 120c) are supplied with the electric supply (140), the respective control unit (150c) connected with the terminal (120c) can be nullified. The nullified control unit (150c) cannot sense the signal from the electric supplied terminal (120c).

In one more alternative embodiment of the rig (100b) (figure 1b), upon storing the circuitry details of the(a) first wire harness (300a) stored in the memory unit (168), the workstation (160) modifies the connections between the terminals (120a) according to the first wire harness (300a) by sending the instructions to the transceiver (152a) to actuate the control unit (150'a) for regulating the supply of electric parameters to the terminal (120a) from the supply device (145) according to the first wire harness (300a). This working of the control unit (150'a, 150'b, 150'c) is shown in figure 4. As the control units (150'a, 150'b, 150'c) regulates the supply device (145), the electric supply (140) is supplied and controlled to the respective terminals (120a, 120b) by the control units (150'a, 150'b, 150'c) connected therewith. In the shown example of harness (figure 1g, 1i), the terminal (120c) can be nullified by the control unit (150'c), as the control unit (150'c) stops the electric supply (140) to the terminal (120c).

For comparing the first wire harness (300a) (for testing the wire harness) with the second wire harness (300b), the second wire harness (300b) is connected to the respective terminal (120a, 120b) (figure 1h and 1j), Upon connecting the second wire harness (300b) to the respective terminals (120b), the electric supply (140) is supplied to the terminals (120b). When the second wire harness (300b) is connected to the terminals (120a, 120b), the electric supply (140) is supplied from the first terminal (120a) to the second terminal (120b) through the second wire harness (300b) in a third cycle of supply (803). Also, the electric supply (140) is supplied from the second terminal (120b) to the first terminal (120a) through the second wire harness (300b) in a fourth cycle of supply (804).

The control units (150a, 150b, 150á, 150b) sends sensed signals to the workstation (160). The processor (166) compares the sensed signals from the control units (150b) with the prestored circuitry details of the first wire harness (300a). The processor (166) provides comparison details through a display (170) connected therewith (refer to figure 1b). The processor (166) is embedded with a set of hardware and software to compare the first wire harness and the second wire harness.

Similarly, the details of the first wire harness (300a) are compared with the second wire harness (300b). For every new testing requirement, the details of a new first wire harness (300a) are stored (modified) in the memory unit (168). The respective comparison (testing) activity is carried on the second wire harness (300b) in comparison to the first harness (300a).

The comparison details include the difference between electrical parameters measured along with the first wire harness (300a) and the second wire harness (300b). In a given example, the first wire harness (300a) has a 5A current, 5V voltage at the first end terminal (120a). The second wire harness (300b) has a 4A current, 4V voltage at the second terminal (120b). The comparison details can be *"current difference of 1A and voltage difference of 1V between the first wire harness (300a) and the second wire harness (300b) ".* The same details can be displayed by the display (170).

These comparison details can be used for testing the wire harnesses (300a, 300b) or for manufacturing the wire harnesses, or tracking errors of comparison operations or for research and development activities.

Similarly, the number of terminals (120a, 120b, 120c) can be increased based on the total number of connector ends (302a, 304a, 302b, 304b) and other specifications of a wire harness (300a, 300b). It may be obvious to a person skilled in the art to configure the rig (100a, 100b) with the number of terminals (increased or decreased) according to the number of connector ends (302a, 304a, 302b, 304b) junctions present in the wire harness (300a, 300b) which needs to compare using the rig (100b).

In an embodiment, the work station (160) is connected to a server (not shown), the comparison details are updated in the server.

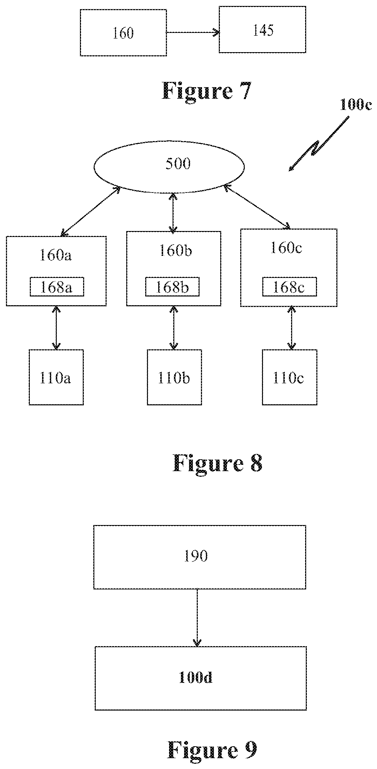

In an alternative embodiment (figure 7), the work station (160) is connected to the supply device (145) to control the electric supply (140) from the supply device (145).

Referring now to figure 8, one more alternative embodiment of the rig (100c) is illustrated. The rig (100c) includes a plurality of work stations (160a, 160b, 160c) and a plurality of workbenches (110a, 110b, 110c). The work stations (160a, 160b, 160c) are connected to a server (500) or a cloud server, the circuitry details of the first wire harness (300a) is updated in the respective memory units (168a, 168b, 168c) of workstations (160a, 160b, 160c). The details of comparison, cycles of comparisons are updated in a cloud memory of the cloud server in real-time.

The details of comparisons can be used to track errors occurred (manual or operational errors) during testing (comparison) operations.

In one more alternative embodiment of the rig (100d), the rig (100d) is connected to an authentication system (190) (refer to figure 9). The authentication system (190) is adapted to provide access to the rig (100d) to an authenticated user only when the authentication system (190) is operated accordingly.

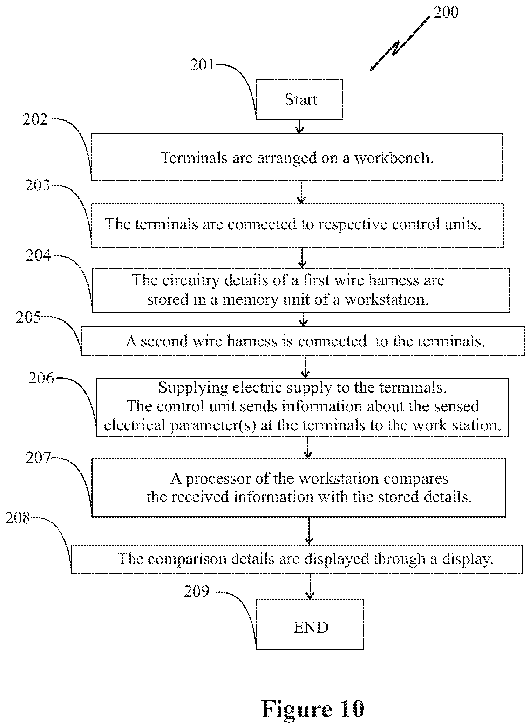

The present invention provides a method (200) (refer to figure 10) for comparing wire harnesses (300a, 300b) (refer to figure 10).

The method (200) starts at step 201.

At step 202, the two or more terminals (120a, 120b) are arranged on the workbench (110).

At step 203, the terminals (120a & 120b) are adapted to receive one or more connector ends (302a, 3024, 302b, 304b) of the wire harness (300a, 300b). The each terminal (120a, 120b) is electrically coupled with the electric supply (140). Further, one terminal (120a, 120b) is connected with the control unit (150a, 150b) of the one or more control units (150a, 150b). The control units (150a, 150b) are connected to a workstation (160) through a wireless network (164). The workstation (160) is having the memory unit (168) and the processor (166).

Further, at step 204, the circuitry details of the first wire harness (300a) of one or more wire harnesses (300) are stored in the memory unit (168).

At step 205, the second wire harness (300b) is connected to the terminals (120a, 120b).

At step 206, the electric supply (140) is supplied to the terminals (120a, 120b), thereby supplying the electrical parameters to the second wire harness (300b). The control units (150a, 150b) are adapted to send information about the sensed electrical parameter(s) at the terminals (120a, 120b) to the work station (160) through the wireless network (164).

At step 207, the processor (166) compares the received information from the control units (150a, 150b) with the prestored circuitry details of the first wire harness (300a).

At step 208, the processor (166) is adapted to provide comparison details through the display (170) connected therewith. The method (200) ends at step 209.

Therefore, the present invention has the advantage of providing the rig (100a, 100b, 100c, 100d) for the wire harnesses (300a, 300b). The rig (100, 100b, 100c, 100d) is used to compare two or more wire harnesses (300a and 300b). The present test rig (100, 100b, 100c, 100d) is used for comparing a single standard wire harness (300a) with multiple other wire harnesses (300b) with modification in circuitry details or vice-versa. As there is a wireless connection (164) is between the control units (150a, 150b, 150'a, 150'b) and the processor (166), the rig (100a, 100b, 100c, 100d) is simple in construction compared to existing testing rigs.

For every new testing (comparison) requirement, the details of a new first wire harness (300a) are stored (modified) in the memory unit (168). The respective comparison (testing) activity is carried on a second wire harness (300b) in comparison to the first harness (300a). Therefore, a new rig is not required for a new requirement of comparing new wire harnesses. Hence, the rig (100) reduces the testing cost of the wire harness (300a, 300b) compared to existing testing rigs (prior arts). The rig (100) is easy to operate. The rig (100a, 100b, 100c, 100d) provides various ways or modes of storing standard wire harness (300) details in a memory unit (168) of the rig (100a, 100b, 100c, 100d) for comparing with other wire harnesses.

The foregoing descriptions of specific embodiments of the present invention have been presented for purposes of illustration and description. They are not intended to be exhaustive or limit the present invention to the precise forms disclosed, and obviously, many modifications and variations are possible in light of the above teaching. The embodiments were chosen and described to best explain the principles of the present invention and its practical application and thereby enable others skilled in the art to best utilise the present invention and various embodiments with various modifications as are suited to the particular use contemplated, since the scope of protection for the present invention is defined by the appended claims.

## Claims

1. A rig (100a or 100b or 100c or 100d) for comparing wire harnesses (300a or 300b), the rig (100a or 100b or 100c or 100d) includes a workbench (110), two or more terminals (120a, 120b, 120c) arranged on the workbench (110), the terminals (120a, 120b) are adapted to receive one or more connector ends (302a, 304a, 302b, 304b) of the wire harness (300a, 300b) and a display (170), each terminal (120a, 120b) is electrically coupled with an electric supply (140),
two or more control units (150a, 150b), each control unit (150a, 150b) is connected to a respective terminal (120a, 120b), each control unit (150a, 150b) is adapted to sense electrical parameters at the respective terminal (120a, 120b) when the respective terminal (120a, 120b) is supplied with the electric supply (140) and generates sensed signals charecterised in that the rig (100a or 100b or 100c or 100d) comprises;
a workstation (160) connected to the control units (150) through a wireless connection (164) to receive sensed signals from the control units (150a, 150b) and to send actuation signals to the control units (150a, 150b), the workstation (160) is having a user interface (162) to configure circuitry details of a first wire harness (300a) and a memory unit (168) for storing prestored circuitry details of the first wire harness (300a) and a processor (166);
wherein upon connecting a second wire harness (300b) to the respective terminals (120b) and supplying the electric supply (140) to the terminals (120a or 120b), the control units (150a or 150b) send sensed signals to the workstation (160), the processor (166) compares the sensed signals from the control units (150a or 150b) with the prestored circuitry details of the first wire harness (300a) and provide comparison details through the display (170) connected therewith.

2. The rig (100a) for wire harnesses (300a or 300b) as claimed in claim 1, configured to evaluate a wire harness that includes one or more wire segments (310a or 310b) and two or more connector ends (302a, 304a, 302b, 304b), connect the one or more wire segments (310a or 310b), the details of circuitry includes a number of junctions (nodes), a number of wire segments (310a or 310b), connectivity between the wire segments (310a & 310b), an electrical continuity or voltage drop along with the wire segments (310a & 310b) and also along with the wire harness (300a, 300b), charge density in the junctions when the wire harness (300a, 300b) is supplied with a predefined quantity of current.

3. The rig (100a) for wire harnesses (300a or 300b) as claimed in claim 1, wherein each terminal (120a, 120b, 120c) is connected to a supply device (145) for receiving electrical parameters therefrom; the electrical parameter is an electrical continuity, an electromotive force (emf) or electrical potential or charge or resistance or impedance or capacitance or utility frequency along the first (300a) or second wire harness (300b).

4. The rig (100a) for wire harnesses (300a or 300b)as claimed in claim 1, wherein a topology of the wireless connection (164) is a mesh topology (164c), or a partially connected mesh, a ring topology (164d), a dual ring topology, a star topology (164a), an extended star topology, a bus topology (164b), a tree topology, hybrid topologies a bus topology or combination thereof.

5. The rig (100a) for wire harnesses (300a or 300b) as claimed in claim 1, wherein the circuitry details are stored in the memory unit (168) by connecting the first wire harness *(300a)* to the corresponding terminals (120a, 120b) and providing electric supply (140) to the first wire harness (300a), the workstation (160) collects information about sensed electrical parameters at the terminals (120a, 120b) from the respective control unit (150a or 150b), wherein the collected information is stored as the circuitry details in the memory unit (168) of the work station (160).

6. The rig (100a) for wire harnesses (300a or 300b) as claimed in claim 1, wherein each control unit (150a, 150b) includes:
a transceiver (152a, 152b) for receiving signals from the workstation (160) and sending signals to the work station (160); and
a sensing unit (154a, 154b) for sensing the electrical parameter, the sensing unit (154a, 154b) is electrically coupled to the terminal (120a, 120b), the sensing unit (154a, 154b) is connected to the transceiver (152a, 152b) for sending sensed signals to the transceiver (152a, 152b).

7. The rig (100a) for wire harnesses (300a or 300b) as claimed in claim 1, wherein upon storing the circuitry details of the first wire harness (300a) stored in the memory (168),
the workstation (160) modifies the connections between the terminals (120a, 120b, 120c) according to the first wire harness (300a) by actuating and nullifying the respective control units (150a, 150b, 150c).

8. The rig (100a) for wire harnesses (300a or 300b) as claimed in claim 3, wherein the supply device (145) is having an interface (147) for controlling operations of the supply device (145).

9. The rig (100b) for wire harnesses (300a or 300b) as claimed in claim 1, wherein each control unit (150'a, 150'b) includes:
a transceiver (152a, 152b) for receiving signals from the workstation (160) and sending signals to the work station (160); and
a sensing unit (154a, 154b) for sensing the electrical parameter, the sensing unit (154a, 154b) is electrical coupled to the terminal (120a, 120b), the sensing unit (154a, 154b) is connected to the transceiver (152a, 152b) for sending sensed signals to the transceiver (152a, 152b);
a regulating unit (156a, 156b) connected to the transceiver (152a, 152b), the supply device (145) and the respective terminal (120a, 120b), wherein as per the instructions received at the transceiver (152a, 152b) from the work station (160), each control unit (150'a, 150'b) regulates the supply of electric parameters to the terminal (120a, 120b) from the supply device (145).

10. The rig (100b) for wire harnesses (300a or 300b) as claimed in claim 1 and 9, wherein upon storing the circuitry details of a first wire harness (300a) stored in the memory unit (168), the workstation (160) modifies the connections between the terminals (120a) according to the first wire harness (300a) by sending the instructions to the transceiver (152a) to actuate the control unit (156a) for regulating the supply of electric parameters (140) to the terminal (120a) from the supply device (145) according to the first wire harness (300a).

11. The rig (100a) for wire harnesses (300a or 300b) as claimed in claim 1, wherein the work station (160) is connected to the supply device (145) to control the electric supply from the supply device (145).

12. The rig (100a) for wire harnesses (300a or 300b) as claimed in claim 1, wherein when the first wire harness (300a) is connected to the terminals (120a, 120b), the electric supply (140) is supplied from a first terminal (120a) to a second terminal (120b) through the first wire harness (300a) in the first cycle of supply (801); the electric supply (140) is supplied from the second terminal (120b) to the first terminal (120a) through the first wire harness (300a) in a second cycle of supply (802); and when the second wire harness (300b) is connected to the termainals (120a, 120b), the electric supply (140) is supplied from the first terminal (120a) to the second terminal (120b) through the second wire harness (300b) in a third cycle of supply (803), the electric supply (140) is supplied from the second terminal (120b) to the first terminal (120a) through the second wire harness (300b) in a fourth cycle of supply (801).

13. The rig (100c) for wire harnesses (300a or 300b) as claimed in claim 1, wherein the rig (100c) includes a plurality of work stations (160a, 160b, 160c), a plurality of workbenches (110a 110b, 110c), the work stations (160a, 160b, 160c) are connected to a server (500) or a cloud server, the circuitry details of the first wire harness (300a) is updated in the respective memory units (168a, 168b, 168c) of workstations (160a, 160b, 160c), the details of comparison, cycles of comparisons are updated in a cloud memory of cloud server on real-time.

14. The rig (100d) for wire harnesses (300a or 300b) as claimed in claim 1, wherein the rig (100d) is connected to an authentication system (190), the authentication system (190) is adapted to provide access to the rig (100d) to an authenticated user only when the authentication system (190) is operated accordingly.

15. A method (200) for comparing wire harnesses (300a or 300b), the method (200) includes steps of arranging two or more terminals (120a, 120b) on a workbench (110), the terminals (120a & 120b) are adapted to receive one or more connector ends (302a, 304a, 302b, 304b) of the wire harness (300a, 300b); electrically coupling each terminal (120a, 120b, 120c) with an electric supply (140),
connecting each terminal (120a, 120b, 120c) with a respective control unit (150a, 150b, 150c) of two or more control units (150a, 150b, 150c), whereby the method comprising the steps of
connecting all control units (150a, 150b, 150c) to a workstation (160) through a wireless network (164), the workstation (160) is having a memory unit (168), a processor (166) and a user interface (162) to configure circuitry details of a first wire harness (300a);
storing the circuitry details of the first wire harness (300a) in the memory unit (168);
connecting a second wire harness (300b) to the terminals (120a, 120b); supplying electric supply (140) to the terminals (120a, 120b), thereby supplying electrical parameters to the second wire harness (300b), wherein the control units (150a, 150b) are adapted to send information about sensed electrical parameters (s) at the terminals (120a, 120b) to the work station (160) through the wireless network (164), the processor (166) is adapted to compare the received information from the control units (150a, 150b) with the prestored circuitry details of the first wire harness (300a) and provide comparison details through a display (170) connected therewith.

## Patentansprüche

1. Vorrichtung (100a oder 100b oder 100c oder 100d) zum Vergleichen von Kabelbäumen (300a oder 300b), wobei die Vorrichtung (100a oder 100b oder 100c oder 100d) umfasst: eine Werkbank (110) sowie zwei oder mehr Anschlüsse (120a, 120b, 120c), die auf der Werkbank (110) angeordnet sind; wobei die Anschlüsse (120a, 120b) dazu ausgelegt sind, ein oder mehrere Steckverbinderenden (302a, 304a, 302b, 304b) des Kabelbaums (300a, 300b) sowie ein Display (170) aufzunehmen, wobei jeder Anschluss (120a, 120b) elektrisch mit einer Stromversorgung (140) verbunden ist,
zwei oder mehr Steuereinheiten (150a, 150b), wobei jede Steuereinheit (150a, 150b) mit einem jeweiligen Anschluss (120a, 120b) verbunden ist, jede Steuereinheit (150a, 150b) ist dazu ausgelegt, elektrische Parameter am jeweiligen Anschluss (120a, 120b) zu erfassen, wenn der jeweilige Anschluss (120a, 120b) mit der Stromversorgung (140) versorgt wird, und Signale erzeugt, **dadurch gekennzeichnet, dass** die Vorrichtung (100a oder 100b oder 100c oder 100d) umfasst:
eine Arbeitsstation (160), die über eine drahtlose Verbindung (164) mit den Steuereinheiten (150) verbunden ist, um erfasste Signale von den Steuereinheiten (150a, 150b) zu empfangen und Ansteuersignale an die Steuereinheiten (150a, 150b) zu senden, wobei die Arbeitsstation (160) über eine Benutzerschnittstelle (162) zur Konfiguration von Schaltungsdetails eines ersten Kabelbaums (300a) und eine Speichereinheit (168) zum Speichern vorab gespeicherter Schaltungsdetails des ersten Kabelbaums (300a) verfügt sowie
einen Prozessor (166);
wobei beim Anschließen eines zweiten Kabelbaums (300b) an die jeweiligen Anschlüsse (120b) und beim Anlegen der Stromversorgung (140) an die Anschlüsse (120a oder 120b) die Steuereinheiten (150a oder 150b) erfasste Signale an die Arbeitsstation (160) senden, der Prozessor (166) die von den Steuereinheiten (150a oder 150b) empfangenen Signale mit den vorab gespeicherten Schaltungsdaten des ersten Kabelbaums (300a) vergleicht und die Vergleichsergebnisse über das damit verbundene Display (170) ausgibt.

2. Vorrichtung (100a) für Kabelbäume (300a oder 300b) nach Anspruch 1, die dazu ausgelegt ist, einen Kabelbaum zu prüfen, der ein oder mehrere Kabelsegmente (310a oder 310b) und zwei oder mehr Steckverbinderenden (302a, 304a, 302b, 304b), die das eine oder die mehreren Leitungssegmente (310a oder 310b) verbinden, umfasst, wobei die Details der Schaltung eine Anzahl von Verbindungsstellen (Knoten), eine Anzahl von Leitungssegmenten (310a oder 310b), die Verbindungen zwischen den Leitungssegmenten (310a und 310b), eine elektrische Durchgängigkeit oder einen Spannungsabfall entlang der Drahtsegmente (310a und 310b) sowie entlang des Kabelbaums (300a, 300b) und die Ladungsdichte in den Verbindungsstellen, wenn der Kabelbaum (300a, 300b) mit einer vordefinierten Strommenge versorgt wird, umfassen.

3. Vorrichtung (100a) für Kabelbäume (300a oder 300b) nach Anspruch 1, wobei jeder Anschluss (120a, 120b, 120c) mit einer Versorgungsvorrichtung (145) verbunden ist, um von dieser elektrische Parameter zu empfangen; wobei der elektrische Parameter eine elektrische Durchgängigkeit, eine elektromotorische Kraft (EMK) oder ein elektrisches Potential oder eine elektrische Ladung oder ein elektrischer Widerstand oder eine Impedanz oder eine Kapazität oder die Netzfrequenz entlang des ersten Kabelbaums (300a) oder zweiten Kabelbaums (300b) ist.

4. Vorrichtung (100a) für Kabelbäume (300a oder 300b) nach Anspruch 1, wobei eine Topologie der drahtlosen Verbindung (164) eine Maschentopologie (164c) oder ein teilweise verbundenes Netz, eine Ringtopologie (164d), eine Doppelring-Topologie, eine Stern-Topologie (164a), eine erweiterte Stern-Topologie, eine Bus-Topologie (164b), eine Baum-Topologie, hybride Topologien, eine Bus-Topologie oder eine Kombination davon ist.

5. Vorrichtung (100a) für Kabelbäume (300a oder 300b) nach Anspruch 1, wobei die Schaltungsdetails in der Speichereinheit (168) gespeichert werden, indem der erste Kabelbaum (300a) an die entsprechenden Anschlüsse (120a, 120b) und durch Zuführen einer Stromversorgung (140) zum ersten Kabelbaum (300a) in der Speichereinheit (168) gespeichert werden, wobei die Arbeitsstation (160) Informationen über erfasste elektrische Parameter an den Anschlüssen (120a, 120b) von der jeweiligen Steuereinheit (150a oder 150b) erfasst, wobei die erfassten Informationen als Schaltungsdetails in der Speichereinheit (168) der Arbeitsstation (160) gespeichert werden.

6. Vorrichtung (100a) für Kabelbäume (300a oder 300b) nach Anspruch 1, wobei jede Steuereinheit (150a, 150b) umfasst:
einen Transceiver (152a, 152b) zum Empfangen von Signalen von der Arbeitsstation (160) und zum Senden von Signalen an die Arbeitsstation (160); und
eine Erfassungseinheit (154a, 154b) zum Erfassen des elektrischen Parameters, wobei die Erfassungseinheit (154a, 154b) elektrisch mit dem Anschluss (120a, 120b) gekoppelt ist, wobei die Erfassungseinheit (154a, 154b) mit dem Transceiver (152a, 152b) verbunden ist, um erfasste Signale an den Transceiver (152a, 152b) zu senden.

7. Vorrichtung (100a) für Kabelbäume (300a oder 300b) nach Anspruch 1, wobei die Arbeitsstation (160) nach dem Speichern der im Speicher (168) gespeicherten Schaltungsdetails des ersten Kabelbaums (300a) die Verbindungen zwischen den Anschlüssen (120a, 120b, 120c) entsprechend dem ersten Kabelbaum (300a) durch Aktivieren und Deaktivieren der jeweiligen Steuereinheiten (150a, 150b, 150c) modifiziert.

8. Vorrichtung (100a) für Kabelbäume (300a oder 300b) nach Anspruch 3, wobei die Versorgungseinrichtung (145) eine Schnittstelle (147) zur Steuerung des Betriebs der Versorgungseinrichtung (145) aufweist.

9. Vorrichtung (100b) für Kabelbäume (300a oder 300b) nach Anspruch 1, wobei jede Steuereinheit (150'a, 150'b) umfasst:
einen Transceiver (152a, 152b) zum Empfangen von Signalen von der Arbeitsstation (160) und zum Senden von Signalen an die Arbeitsstation (160); und
eine Erfassungseinheit (154a, 154b) zum Erfassen des elektrischen Parameters, wobei die Erfassungseinheit (154a, 154b) elektrisch mit dem Anschluss (120a, 120b) gekoppelt ist, wobei die Erfassungseinheit (154a, 154b) mit dem Transceiver (152a, 152b) verbunden ist, um erfasste Signale an den Transceiver (152a, 152b) zu senden;
eine Regeleinheit (156a, 156b), die mit dem Transceiver (152a, 152b), der Versorgungsvorrichtung (145) und dem jeweiligen Anschluss (120a, 120b) verbunden ist, wobei gemäß den am Transceiver (152a, 152b) von der Arbeitsstation (160) empfangenen Anweisungen jede Steuereinheit (150'a, 150'b) die Zufuhr elektrischer Parameter von der Versorgungsvorrichtung (145) zum Anschluss (120a, 120b) regelt.

10. Vorrichtung (100b) für Kabelbäume (300a oder 300b) gemäß den Ansprüchen 1 und 9, wobei nach dem Speichern der Schaltungsdetails eines ersten Kabelbaums (300a) in der Speichereinheit (168) die Arbeitsstation (160) die Verbindungen zwischen den Anschlüssen (120a) entsprechend dem ersten Kabelbaum (300a) modifiziert, indem sie Anweisungen an den Transceiver (152a) sendet, um die Regeleinheit (156a) zur Regelung der Zufuhr elektrischer Parameter (140) zum Anschluss (120a) von der Versorgungsvorrichtung (145) entsprechend dem ersten Kabelbaum (300a) zu regeln.

11. Vorrichtung (100a) für Kabelbäume (300a oder 300b) nach Anspruch 1, wobei die Arbeitsstation (160) mit der Versorgungsvorrichtung (145) verbunden ist, um die Stromversorgung von der Versorgungsvorrichtung (145) zu steuern.

12. Vorrichtung (100a) für Kabelbäume (300a oder 300b) nach Anspruch 1, wobei, wenn der erste Kabelbaum (300a) an die Anschlüsse (120a, 120b) angeschlossen ist, die Stromversorgung (140) im ersten Versorgungszyklus (801) von einem ersten Anschluss (120a) über den ersten Kabelbaum (300a) zu einem zweiten Anschluss (120b) geleitet wird; die Stromversorgung (140) im zweiten Versorgungszyklus (802) über den ersten Kabelbaum (300a) von dem zweiten Anschluss (120b) zum ersten Anschluss (120a) geleitet wird; und wenn der zweite Kabelbaum (300b) an die Anschlüsse (120a, 120b) angeschlossen ist, die Stromversorgung (140) im dritten Versorgungszyklus (803) über den zweiten Kabelbaum (300b) vom ersten Anschluss (120a) zum zweiten Anschluss (120b) geleitet wird, in einem vierten Versorgungszyklus (801) wird die Stromversorgung (140) über den zweiten Kabelbaum (300b) von dem zweiten Anschluss (120b) zum ersten Anschluss (120a) geleitet.

13. Vorrichtung (100c) für Kabelbäume (300a oder 300b) nach Anspruch 1, wobei die Vorrichtung (100c) eine Vielzahl von Arbeitsstationen (160a, 160b, 160c), eine Vielzahl von Werkbänken (110a, 110b, 110c) umfasst, wobei die Arbeitsstationen (160a, 160b, 160c) mit einem Server (500) oder einem Cloud-Server verbunden sind, wobei die Schaltungsdetails des ersten Kabelbaums (300a) in den jeweiligen Speichereinheiten (168a, 168b, 168c) der Arbeitsstationen (160a, 160b, 160c) aktualisiert werden, wobei die Vergleichsdaten sowie die Vergleichszyklen in Echtzeit in einem Cloud-Speicher des Cloud-Servers aktualisiert.

14. Vorrichtung (100d) für Kabelbäume (300a oder 300b) nach Anspruch 1, wobei die Vorrichtung (100d) mit einem Authentifizierungssystem (190) verbunden ist, wobei das Authentifizierungssystem (190) so ausgelegt ist, dass es einem authentifizierten Benutzer nur dann Zugriff auf die Vorrichtung (100d) gewährt, wenn das Authentifizierungssystem (190) entsprechend betrieben wird.

15. Verfahren (200) zum Vergleichen von Kabelbäumen (300a oder 300b), wobei das Verfahren (200) die folgenden Schritte umfasst:
Anordnen von zwei oder mehr Anschlüssen (120a, 120b) auf einer Werkbank (110), wobei die Anschlüsse (120a und 120b) dazu ausgelegt sind, ein oder mehrere Steckverbinderenden (302a, 304a, 302b, 304b) des Kabelbaums (300a, 300b) aufzunehmen; und jeden Anschluss (120a, 120b, 120c) elektrisch mit einer Stromversorgung (140) zu verbinden,
Verbinden jedes Anschlusses (120a, 120b, 120c) mit einer jeweiligen Steuereinheit (150a, 150b, 150c) von zwei oder mehr Steuereinheiten (150a, 150b, 150c), wobei das Verfahren die folgenden Schritte umfasst:
Verbinden aller Steuereinheiten (150a, 150b, 150c) mit einer Arbeitsstation (160) über ein drahtloses Netzwerk (164), wobei die Arbeitsstation (160) eine Speichereinheit (168), einen Prozessor (166) und eine Benutzerschnittstelle (162) zum Konfigurieren von Schaltungsdetails eines ersten Kabelbaums (300a) umfasst;
Speichern der Schaltungsdetails des ersten Kabelbaums (300a) in der Speichereinheit (168);
Anschließen eines zweiten Kabelbaums (300b) an die Anschlüsse (120a, 120b);
Bereitstellen der Stromversorgung (140) an die Anschlüsse (120a, 120b), wodurch elektrische Parameter an den zweiten Kabelbaum (300b) geliefert werden, wobei die Steuereinheiten (150a, 150b) dazu ausgelegt sind, Informationen über an den Anschlüssen (120a, 120b) erfasste elektrische Parameter über das drahtlose Netzwerk (164) an die Arbeitsstation (160) zu senden, wobei der Prozessor (166) dazu ausgelegt ist, die von den Steuereinheiten (150a, 150b) empfangenen Informationen mit den vorab gespeicherten Schaltungsdetails des ersten Kabelbaums (300a) zu vergleichen und die Vergleichsergebnisse über ein damit verbundenes Display (170) bereitzustellen.

## Revendications

1. Équipement (100a ou 100b ou 100c ou 100d) permettant de comparer des faisceaux de câbles (300a ou 300b), l'équipement (100a ou 100b ou 100c ou 100d) comprend un établi (110), au moins deux bornes (120a, 120b, 120c) disposées sur l'établi (110), les bornes (120a, 120b) sont conçues pour recevoir une ou plusieurs extrémités de connecteur (302a, 304a, 302b, 304b) du faisceau de câbles (300a, 300b) et un dispositif d'affichage (170), chaque borne (120a, 120b) est couplée électriquement à une alimentation électrique (140),
au moins deux unités de commande (150a, 150b), chaque unité de commande (150a, 150b) est connectée à une borne (120a, 120b) respective, chaque unité de commande (150a, 150b) est conçue pour détecter des paramètres électriques au niveau de la borne (120a, 120b) respective lorsque la borne (120a, 120b) respective est alimentée en alimentation électrique (140) et génère des signaux détectés, **caractérisé en ce que** l'équipement (100a ou 100b ou 100c ou 100d) comprend :
une station de travail (160) connectée aux unités de commande (150) par l'intermédiaire d'une connexion sans fil (164) pour recevoir des signaux détectés provenant des unités de commande (150a, 150b) et pour envoyer des signaux d'actionnement aux unités de commande (150a, 150b), la station de travail (160) est dotée d'une interface utilisateur (162) pour configurer des détails de l'ensemble des circuits d'un premier faisceau de câbles (300) et une unité de mémoire (168) pour enregistrer des détails de l'ensemble des circuits pré-stockés du premier faisceau de câbles (300a) et un processeur (166) ;
**en ce que** lors de la connexion d'un deuxième faisceau de câbles (300b) aux bornes (120b) respectives et de la fourniture de l'alimentation électrique (140) aux bornes (120a ou 120b), les unités de commande (150a ou 150b) envoient des signaux détectés à la station de travail (160), le processeur (166) compare les signaux détectés provenant des unités de commande (150a ou 150b) aux détails de l'ensemble des circuits pré-stockés du premier faisceau de câbles (300a) et fournit des détails de comparaison par l'intermédiaire du dispositif d'affichage (170) qui y est connecté.

2. Équipement (100a) pour faisceaux de câbles (300a ou 300b) selon la revendication 1, conçu pour évaluer un faisceau de câbles qui comprend un ou plusieurs segments de câbles (310a ou 310b) et au moins deux extrémités de connecteur (302a, 304a, 302b, 304b), connecter ledit ou lesdits segments de câbles (310a ou 310b), les détails de l'ensemble des circuits comprennent un nombre de jonctions (nœuds), un nombre de segments de câbles (310a ou 310b), la connectivité entre les segments de câbles (310a et 310b), une continuité électrique ou une chute de tension le long des segments de câbles (310a et 310b) ainsi que le long du faisceau de câbles (300a, 300b), la densité de charge dans les jonctions lorsque le faisceau de câbles (300a, 300b) est alimenté par une quantité prédéfinie de courant.

3. Équipement (100a) pour faisceaux de câbles (300a ou 300b) selon la revendication 1, en ce que chaque borne (120a, 120b, 120c) est connectée à un dispositif d'alimentation (145) afin de recevoir de ce dernier des paramètres électriques ; le paramètre électrique est une continuité électrique, une force électromotrice (emf) ou un potentiel électrique ou une charge ou résistance ou impédance ou capacité ou fréquence du réseau le long du premier (300a) ou du deuxième faisceau de câbles (300b).

4. Équipement (100a) pour faisceaux de câbles (300a ou 300b) selon la revendication 1, en ce qu'une topologie de la connexion sans fil (164) est une topologie maillée (164c), ou un maillage partiellement connecté, une topologie en anneau (164d), une topologie à deux anneaux, une topologie en étoile (164a), une topologie en étoile étendue, une topologie en bus (164b), une topologie en arbre, des topologies hybrides telles qu'une topologie en bus ou une combinaison de celles-ci.

5. Équipement (100a) pour faisceaux de câbles (300a ou 300b) selon la revendication 1, en ce que les détails de l'ensemble des circuits sont enregistrés dans l'unité de mémoire (168) en connectant le premier faisceau de câbles (300a) aux bornes (120a, 120b) correspondantes et en fournissant l'alimentation électrique (140) au premier faisceau de câbles (300a), la station de travail (160) collecte des informations relatives aux paramètres électriques détectés au niveau des bornes (120a, 120b) provenant de l'unité de commande (150a ou 150b) respective, en ce que les informations collectées sont enregistrées en tant que détails de l'ensemble des circuits dans l'unité de mémoire (168) de la station de travail (160).

6. Équipement (100a) pour faisceaux de câbles (300a ou 300b) selon la revendication 1, en ce que chaque unité de commande (150a, 150b) comprend :
un émetteur-récepteur (152a, 152b) pour recevoir des signaux provenant de la station de travail (160) et envoyer des signaux à la station de travail (160) ; et
une unité de détection (154a, 154b) pour détecter le paramètre électrique, l'unité de détection (154a, 154b) est couplée électriquement à la borne (120a, 120b), l'unité de détection (154a, 154b) est connectée à l'émetteur-récepteur (152a, 152b) pour envoyer des signaux détectés à l'émetteur-récepteur (152a, 152b).

7. Équipement (100a) pour faisceaux de câbles (300a ou 300b) selon la revendication 1, en ce que, une fois les détails de l'ensemble des circuits du premier faisceau de câbles (300a) enregistrés dans l'unité de mémoire (168), la station de travail (160) modifie les connexions entre les bornes (120a, 120b, 120c) conformément au premier faisceau de câbles (300a) en actionnant et en annulant les unités de commande (150a, 150b, 150c) respectives.

8. Équipement (100a) pour faisceaux de câbles (300a ou 300b) selon la revendication 3, en ce que le dispositif d'alimentation (145) est doté d'une interface (147) pour commander le fonctionnement du dispositif d'alimentation (145).

9. Équipement (100b) pour faisceaux de câbles (300a ou 300b) selon la revendication 1, en ce que chaque unité de commande (150'a, 150'b) comprend :
un émetteur-récepteur (152a, 152b) pour recevoir des signaux de la station de travail (160) et envoyer des signaux à la station de travail (160) ; et
une unité de détection (154a, 154b) pour détecter le paramètre électrique, l'unité de détection (154a, 154b) est couplée électriquement à la borne (120a, 120b), l'unité de détection (154a, 154b) est connectée à l'émetteur-récepteur (152a, 152b) pour envoyer des signaux détectés à l'émetteur-récepteur (152a, 152b) ;
une unité de régulation (156a, 156b) connectée à l'émetteur-récepteur (152a, 152b), au dispositif d'alimentation (145) et à la borne (120a, 120b) respective, en ce que conformément aux instructions reçues au niveau de l'émetteur-récepteur (152a, 152b) en provenance de la station de travail (160), chaque unité de commande (150'a, 150'b) régule l'alimentation de paramètres électriques vers la borne (120a, 120b) depuis le dispositif d'alimentation (145).

10. Équipement (100b) pour faisceaux de câbles (300a ou 300b) selon la revendication 1 et 9, en ce que, à enregistrement des détails de l'ensemble des circuits d'un premier faisceau de câbles (300a) enregistrés dans l'unité de mémoire (168), la station de travail (160) modifie les connexions entre les bornes (120a) conformément au premier faisceau de câbles (300a) en envoyant à l'émetteur-récepteur (152a) des instructions destinées à actionner l'unité de commande (156a) afin de réguler l'alimentation des paramètres électriques (140) vers la borne (120a) depuis le dispositif d'alimentation (145) conformément au premier faisceau de câbles (300a).

11. Équipement (100a) pour faisceaux de câbles (300a ou 300b) selon la revendication 1, en ce que la station de travail (160) est connectée au dispositif d'alimentation (145) afin de commander l'alimentation électrique à partir du dispositif d'alimentation (145).

12. Équipement (100a) pour faisceaux de câbles (300a ou 300b) selon la revendication 1, en ce que lorsque le premier faisceau de câbles (300a) est connecté aux bornes (120a, 120b), l'alimentation électrique (140) est fournie à partir d'une première borne (120a) vers une deuxième borne (120b) par l'intermédiaire du premier faisceau de câbles (300a) dans le premier cycle d'alimentation (801) ; l'alimentation électrique (140) est fournie à partir de la deuxième borne (120b) vers la première borne (120a) par l'intermédiaire du premier faisceau de câbles (300a) dans un deuxième cycle d'alimentation (802) ; et lorsque le deuxième faisceau de câbles (300b) est connecté aux bornes (120a, 120b), l'alimentation électrique (140) est fournie à partir de la première borne (120a) vers la deuxième borne (120b) par l'intermédiaire du deuxième faisceau de câbles (300b) dans un troisième cycle d'alimentation (803), l'alimentation électrique (140) est fournie à partir de la deuxième borne (120b) vers la première borne (120a) par l'intermédiaire du deuxième faisceau de câbles (300b) dans un quatrième cycle d'alimentation (801).

13. Équipement (100c) pour faisceaux de câbles (300a ou 300b) selon la revendication 1, en ce que l'équipement (100c) comprend une pluralité de stations de travail (160a, 160b, 160c), une pluralité d'établis (110a, 110b, 110c), les stations de travail (160a, 160b, 160c) sont connectées à un serveur (500) ou à un serveur en nuage, les détails de l'ensemble des circuits du premier faisceau de câbles (300a) sont mis à jour dans les unités de mémoire (168a, 168b, 168c) respectives des stations de travail (160a, 160b, 160c), les détails de comparaison, les cycles de comparaison sont mis à jour dans une mémoire en nuage du serveur en nuage en temps réel.

14. Équipement (100d) pour faisceaux de câbles (300a ou 300b) selon la revendication 1, en ce que l'équipement (100d) est connecté à un système d'authentification (190), le système d'authentification (190) est conçu pour permettre l'accès à l'équipement (100d) à un utilisateur authentifié uniquement lorsque le système d'authentification (190) est utilisé en conséquence.

15. Procédé (200) de comparaison de faisceaux de câbles (300a, 300b), le procédé (200) comprend les étapes consistant à disposer au moins deux bornes (120a, 120b) sur un établi (110), les bornes (120a et 120b) sont conçues pour recevoir une ou plusieurs extrémités de connecteur (302a, 304a, 302b, 304b) du faisceau de câbles (300a, 300b) ; à coupler électriquement chaque borne (120a, 120b, 120c) à une alimentation électrique (140),
connecter chaque borne (120a, 120b, 120c) à une unité de commande (150a, 150b, 150c) respective de deux ou plusieurs unités de commande (150a, 150b, 150c), le procédé comprenant les étapes consistant à
connecter toutes les unités de commande (150a, 150b, 150c) à une station de travail (160) par l'intermédiaire d'un réseau sans fil (164), la station de travail (160) est dotée d'une unité de mémoire (168), d'un processeur (166) et d'une interface utilisateur (162) pour configurer des détails de l'ensemble des circuits d'un premier faisceau de câbles (300) ;
enregistrer les détails de l'ensemble des circuits du premier faisceau de câbles (300a) dans l'unité de mémoire (168) ;
connecter un deuxième faisceau de câbles (300b) aux bornes (120a, 120b) ;
fournir une alimentation électrique (140) aux bornes (120a, 120b), permettant ainsi de transmettre les paramètres électriques au deuxième faisceau de câbles (300b), en ce que les unités de commande (150a, 150b) sont conçues pour envoyer des informations relatives aux paramètres électriques détectés (s) au niveau des bornes (120a, 120b) à la station de travail (160) par l'intermédiaire du réseau sans fil (164), le processeur (166) est conçu pour comparer les informations reçues des unités de commande (150a, 150b) aux détails de l'ensemble des circuits pré-stockés du premier faisceau de câbles (300a) et fournit des détails de comparaison par l'intermédiaire d'un dispositif d'affichage (170) qui y est connecté.
